# EUROPEAN PATENT APPLICATION

(11) **EP 3 540 091 A1**
(43) Date of publication of application: **18.09.2019**
(21) Application number: 19163303.1
(22) Date of filing: 15.03.2019
(51) Int. Cl.: C23C 16/04, C23C 16/40, C23C 16/455, F01D 5/18, F01D 5/28, F01D 9/06, F01D 25/00

(54) **TURBINE AIRFOIL WITH INTERNALS COATED BY ATOMIC LAYER DEPOSITION**

(30) Priority: 16.03.2018 US 201815923427
(71) Applicant: United Technologies Corporation, Farmington, CT 06032 (US)
(72) Inventor: TASK, Michael N, Vernon, CT Connecticut 06066 (US); SCHLICHTING, Kevin W, South Glastonbury, CT Connecticut 06073 (US); MALONEY, Michael J, Marlborough, CT Connecticut 06447 (US); MAGDEFRAU, Neal, Tolland, CT Connecticut 06084 (US); SHEEDY, Paul, Bolton, CT Connecticut 06043 (US)
(74) Representative: Dehns

(57) **Abstract**

A process for coating a gas turbine engine airfoil (32) comprising coupling the airfoil (32) having an internal surface (62) with a chamber, the chamber configured to perform atomic layer deposition; injecting a first reactant (66) into the chamber; forming a first monolayer gas thin film on the internal surface (62); removing the first reactant (66) from the chamber; injecting a second reactant (68) into the chamber; forming a reaction with the first monolayer gas film to form a solid thin film (72); removing the second reactant (68) from the chamber; and forming a protective barrier coating (64) on said internal surface (62).

## Description

### BACKGROUND

The present disclosure is directed to a process for coating gas turbine engine blade/vane airfoil internal surfaces.

Gas turbine engines are required to be more efficient, so as a result the gas temperatures within the engines have been increased. The ability to operate at these increased temperatures is limited by the ability of the components to maintain their mechanical strength when exposed to the heat, oxidation, and corrosive effects of the impinging gas.

The internal passages of cooled high pressure turbine (HPT) blades/vanes experience surface degradation due to high temperature oxidation and/or deposit induced hot corrosion. Currently available coating processes are aluminizing (resistant to high temperature oxidation) and chromizing (resistant to hot corrosion). Neither coating provides sufficient protection against the broad range of conditions (temperature, environment) that are experienced on the internals of a turbine blade/vane. A process is required which has complete non-line-of-site (NLOS) deposition capability and can deposit robust coatings that can resist the many degradation modes experienced in HPT components.

It is desired to protect the blade/vane airfoil internal surface materials from the high temperature oxidation and/or deposit induced hot corrosion.

### SUMMARY

In accordance with the present disclosure, there is provided a process for coating a gas turbine engine airfoil comprising coupling the airfoil having an internal surface with a chamber, the chamber configured to perform atomic layer deposition; injecting a first reactant into the chamber so as to form a first monolayer gas thin film on the internal surfaces; removing the first reactant from the chamber; injecting a second reactant into the chamber so as to react to form a monolayer solid thin film; removing the second reactant from the chamber; and forming a protective barrier coating on the internal surface.

In another and alternative embodiment, the process further comprises determining a thickness of the protective barrier coating; and repeating the steps of injecting and removing the first reactant and repeating the step of injecting and removing the second reactant responsive to determining the thickness of the protective barrier coating.

In another and alternative embodiment, the process further comprises prior to injecting the first reactant into the chamber, creating a predetermined pressure in the chamber; and heating the chamber to a predetermined temperature.

In another and alternative embodiment, the predetermined temperature enables the step of forming a first monolayer gas thin film on the internal surfaces and the step of injecting the second reactant to form the monolayer solid thin film.

In another and alternative embodiment, the first reactant comprises an oxide precursor and the second reactant comprises an oxidant.

In another and alternative embodiment, the first reactant comprises a metal precursor and the second reactant comprises an oxidant.

In another and alternative embodiment, the first monolayer gas thin film and the second reactant react to form the protective barrier coating comprising Al₂O₃.

In another and alternative embodiment, the thin film coating comprises a total thickness of from about 0.1 micron to about 10 microns.

In another and alternative embodiment, the total thickness is configured to reduce internal corrosion.

In another and alternative embodiment, the first reactant and the second reactant form the protective barrier coating comprising a material selected from the group consisting of Ta₂O₅, ZrO₂, TiO_{2,} Cr₂O₃ and precursors selected from the group consisting of Me- halides, alkyls, alkoxides, β-diketonates, where Me = Al, Cr, Ti, Si, Zr, Hf, Y, Ta, Nb, Ce, La, Yb, Mg, Ni, Co, and Mn.

In another and alternative embodiment, the process further comprises after completion of forming the protective barrier coating bringing the chamber to an ambient temperature and pressure.

In another and alternative embodiment, the internal surface is located in an airfoil internal cooling passage.

In another and alternative embodiment, the process further comprises coupling a manifold configured to flow the first reactant and the second reactant into the internal cooling passages; flowing the first reactant into the internal cooling passage; removing the first reactant from the internal cooling passage; flowing the second reactant into the internal cooling passage; and removing the second reactant from the internal cooling passage.

In another and alternative embodiment, the process further comprises masking airfoil surfaces not intended for coating.

In accordance with the present disclosure, there is provided a gas turbine engine airfoil internal surface comprising a protective barrier coating formed by the method recited in claim 1.

In another and alternative embodiment, the protective barrier coating comprises Al₂O₃.

In another and alternative embodiment, the protective barrier coating is a material selected from the group consisting of Ta₂O₅, ZrO₂, TiO_{2,} Cr₂O₃ and precursors selected from the group consisting of Me- halides, alkyls, alkoxides, β-diketonates, where Me = Al, Cr, Ti, Si, Zr, Hf, Y, Ta, Nb, Ce, La, Yb, Mg, Ni, Co, and Mn.

In another and alternative embodiment, the protective barrier coating comprises multiple layers.

In another and alternative embodiment, the airfoil internal surface is at least one of a blade of a high pressure turbine and a vane of a high pressure turbine.

In another and alternative embodiment, the protective barrier coating has a thickness configured to minimize an internal corrosion at temperatures exceeding 1800 degrees Fahrenheit.

Other details of the process for coating are set forth in the following detailed description and the accompanying drawings wherein like reference numerals depict like elements.

### BRIEF DESCRIPTION OF THE DRAWINGS

FIG. 1 is a schematic longitudinal sectional view of a turbofan engine;
FIG. 2 illustrates a cross sectional view of an exemplary blade in accordance with various embodiments;
FIG. 3 is a cross-sectional illustration of an exemplary blade/vane airfoil internal surface coating in accordance with various embodiments;
FIG. 4 is a schematic of an exemplary atomic layer coating apparatus incorporated with a blade/vane.
FIG. 5 is an exemplary process map.

### DETAILED DESCRIPTION

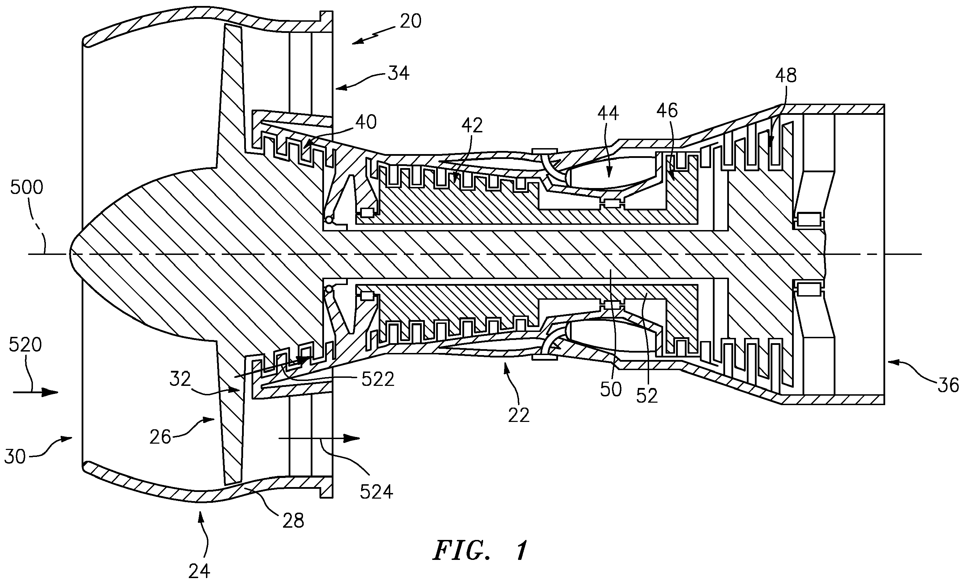

FIG. 1 shows a gas turbine engine 20 having an engine case 22 surrounding a centerline or central longitudinal axis 500. An exemplary gas turbine engine is a turbofan engine having a fan section 24 including a fan 26 within a fan case 28. The exemplary engine includes an inlet 30 at an upstream end of the fan case receiving an inlet flow along an inlet flow path 520. The fan 26 has one or more stages of fan blades 32. Downstream of the fan blades, the flow path 520 splits into an inboard portion 522 being a core flow path and passing through a core of the engine and an outboard portion 524 being a bypass flow path exiting an outlet 34 of the fan case.

The core flow path 522 proceeds downstream to an engine outlet 36 through one or more compressor sections, a combustor, and one or more turbine sections. The exemplary engine has two axial compressor sections and two axial turbine sections, although other configurations are equally applicable. From upstream to downstream there is a low pressure compressor section (LPC) 40, a high pressure compressor section (HPC) 42, a combustor section 44, a high pressure turbine section (HPT) 46, and a low pressure turbine section (LPT) 48. Each of the LPC, HPC, HPT, and LPT comprises one or more stages of blades which may be interspersed with one or more stages of stator vanes.

In the exemplary engine, the blade stages of the LPC and LPT are part of a low pressure spool mounted for rotation about the axis 500. The exemplary low pressure spool includes a shaft (low pressure shaft) 50 which couples the blade stages of the LPT to those of the LPC and allows the LPT to drive rotation of the LPC. In the exemplary engine, the shaft 50 also directly drives the fan. In alternative implementations, the fan may be driven via a transmission (e.g., a fan gear drive system such as an epicyclical transmission) to allow the fan to rotate at a lower speed than the low pressure shaft.

The exemplary engine further includes a high pressure shaft 52 mounted for rotation about the axis 500 and coupling the blade stages of the HPT to those of the HPC to allow the HPT to drive rotation of the HPC. In the combustor 44, fuel is introduced to compressed air from the HPC and combusted to produce a high pressure gas which, in turn, is expanded in the turbine sections to extract energy and drive rotation of the respective turbine sections and their associated compressor sections (to provide the compressed air to the combustor) and fan.

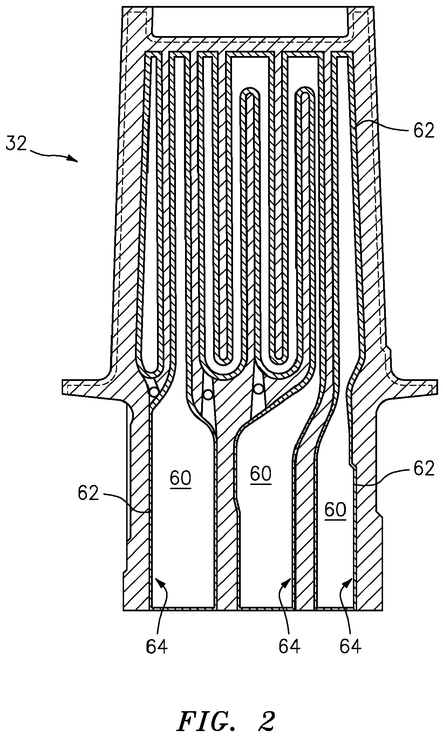

Referring to Fig. 2 an exemplary blade 32 is illustrated. The exemplary blade 32 shown can be a high pressure turbine blade or a high pressure turbine vane. The blade 32 is shown with internal passages 60. The internal passages 60 of the blade 32 includes internal surface/surfaces 62. These internal surfaces 62 are subjected to the above described degradation modes experienced in the HPT.

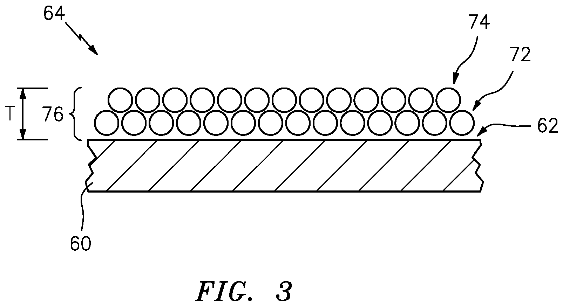

Referring also to Fig. 3, the blade 32, which can be a fan blade, a compressor blade, a turbine blade or vanes and the like. For the purposes of this disclosure, blade is used generically. The blade 32 comprises an alloy and includes coatings that are used for the high temperature structural applications in which the blade 32 is utilized. In an exemplary embodiment the internal surface 62 can include a protective barrier coating 64. In an exemplary embodiment the coating can include a protective barrier coating 64 comprising an oxide, such as Al₂O₃. However, blade 32 alloy compositions often cannot be optimized for the purpose of coating because of mechanical property considerations, so the alloys may be borderline Al₂O₃ formers. The result is that oxide scale growth can be inhomogeneous over the internal surface 62, with certain locations not forming these protective oxides under certain conditions. Also, upon forming the scales, the Al in the underlying alloy is depleted, so when the scale sustains damage, the alloy may be unable to repair the oxide coating 64, resulting in rapid corrosion rates.

In the exemplary process, using ALD to deposit the oxides, the oxide coating 64 can be uniformly formed over the entire internal surface 62 of the passages 60. The exemplary process is functional in non-line-of-sight areas of the internal passages 60, with no depletion of the elements in the underlying alloy.

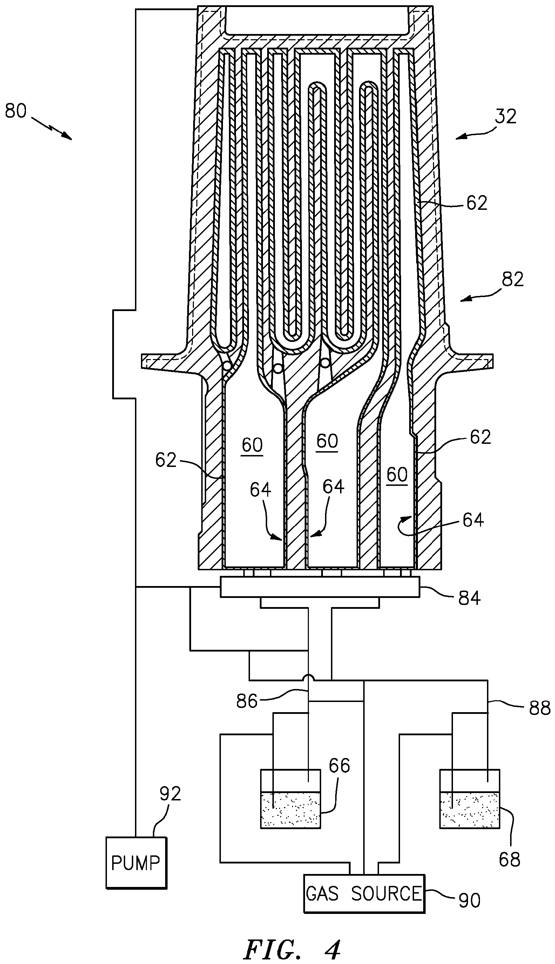

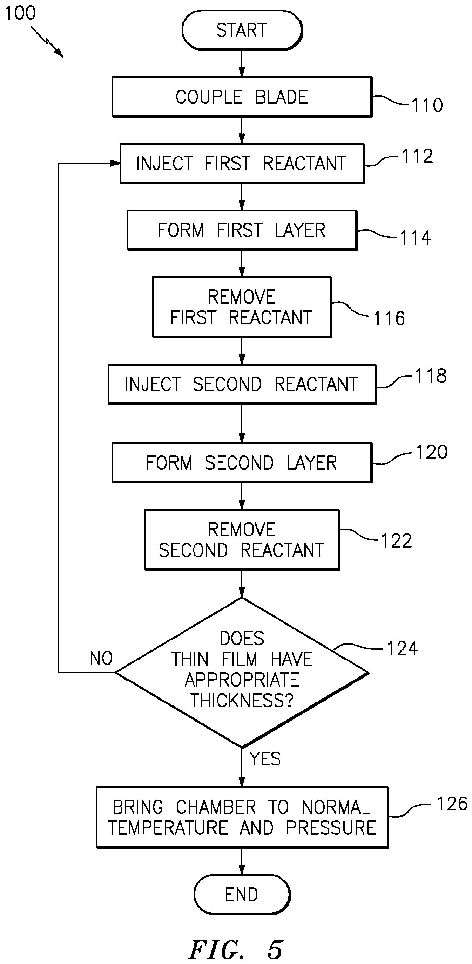

Referring also to Figs. 4 and 5, ALD is a form of chemical vapor deposition (CVD) in which alternating precursor chemicals, such as a first reactant 66 and a second reactant 68 are introduced into a chamber, take part in a surface-limited chemical reaction, and build up a coating in an A-B-A-B-A-B layered manner. In an exemplary embodiment the precursor gases are introduced as A-B-A-B. The actual final coating, in this case, is not a layered structure, but a single oxide phase. The first reactant adsorbs on the surface as a gas, the second reactant is specifically designed to react with the first reactant to form a stable compound, such as Al₂O₃. In exemplary embodiments, the chamber can be a vacuum chamber or low pressure chamber or an atmospheric chamber, set to a predetermined atmospheric pressure.

The coating 64 can include a first monolayer thin film 72 on the internal surface 62. The first monolayer thin film 64 is laid down from the first reactant A as a gas. The first reactant will form a solid after it reacts with the second reactant B and forms the monolayer thin film 72. In the exemplary embodiment shown at Fig. 3, layers 76 are shown as two layers, first layer 72 and second layer 74, it is contemplated that multiple layers 76 can be utilized. In exemplary embodiments, the reaction sequence is A-B-A-B-A-B, but the protective barrier coating 64 may not be explicitly built up of monolayers of A and B as the second reactant 68 (reactant B) can react with the 'monolayer' of the first reactant 66 (reactant A) to form the protective barrier coating 64. In other exemplary embodiments, not every cycle of the reaction sequence can involve adsorption or reaction of a complete monolayer, therefore the term monolayer can include both full monolayers and partial monolayer structure.

In other exemplary embodiments, the multiple layers 76 can comprise multiple layers of the same chemistry, and in another exemplary embodiments the multiple layers 76 can be varied chemistries, such as Al₂O₃/Cr₂O₃. For example, the multiple layers 76 can comprise one or more layers of oxide A followed by one or more layers of oxide B or alternatively, alternating one or more layers of oxide A and one or more layers oxide B.

In another exemplary embodiment, the multiple layers 76 can include more than two chemistries as are embodiments where two discretely deposited chemistries diffuse together to form a single phase (e.g. Al₂O₃-Cr₂O₃).

The first reactant 66 can include an oxide precursor and the second reactant can include an oxidant. Examples of the first reactant 66 can be selected from available precursors for the desired metal (oxide) phase(s), for example, Me- halides (for example Al(Cl)3), alkyls (such as, trimethyl aluminum), alkoxides (such as, aluminum ethoxide), β-diketonates (such as, aluminum acetylacetonate) are among the more common classes of precursors, where Me = Al, Cr, Ti, Si, Zr, Hf, Y, Ta, Nb, Ce, La, Yb, Mg, Ni, Co, Mn.

In another exemplary embodiment, when the protective barrier coating 64 is an oxide, then the second reactant 68 can be water, molecular oxygen (O2), and ozone (O3). In another embodiment, atomic oxygen (such as, oxygen plasma) could also be an option, but due to line of sight issues may be a less likely option.

Al₂O₃ is generally favorable for high temperature oxidation resistance, i.e., oxidation at temperatures exceeding approximately 1800 degrees Fahrenheit (982.2°C). In typical blade applications, internal walls will reach 1800 degree Fahrenheit (982.2°C), particularly under certain engine operating conditions, such as during takeoff. In another exemplary embodiment, alternative ceramic coatings could be utilized, such as Ta₂O₅, ZrO₂, and TiO₂, as well as oxides selected from the list of precursors above, including multiphase or mixed oxides containing two or more components, and the like.

In an alternative embodiment, a Pt metal can be utilized as a reactant to form a protective barrier coating including a Pt-modified aluminide material composition on the internal surfaces 62. A Pt precursor material can be utilized as a reactant with the ALD process. In other exemplary embodiments, non-oxide precursors can be employed as a reactant, such as nitrides and oxy-nitrides.

In an exemplary embodiment a thickness T can range from about a 0.1-10 micron range. In an exemplary embodiment, a certain thickness is desired to give adequate environmental protection, which establishes the lower limit. In an exemplary embodiment an upper limit can be defined by two factors. First, particularly in the case of disks, the component is very sensitive to fatigue, and the fatigue debit associated with a coating generally trends with coating thickness. The thinner the coating the better, from a fatigue standpoint. Secondly, ALD is a relatively slow process, so there is a practical limit to how long a part can be in a coating device.

Referring also to Fig. 4 and 5, the exemplary process 100 is illustrated with reference to the exemplary coating apparatus 80. The blade 32 with internal passages 60 can be utilized as a chamber 82, by coupling a manifold 84 to the internal passages 60 at step 110. The internal passages 60 utilized as the chamber 82 can be configured to perform atomic layer deposition. In another exemplary embodiment, the blade 32 can be placed inside a conventional chamber (not shown), such that reactants 66, 68 can be applied to internal surfaces 62.

After the chamber 82 temperature and pressure have been established, the first reactant 66 can be injected into the chamber 82 through line 86, at step 112. The first reactant 66 can nominally form the first monolayer gas thin film 72 on the internal surfaces 62, at step 114. At step 116, the first reactant 66 is removed from the chamber 82.

The second reactant 68 can be injected into the chamber 82 through line 88, at step 118. The second reactant 68 can react with the adsorbed first monolayer gas thin film 72 to form a solid layer, at step 120 resulting in a layer of the protective barrier coating 64. At step 122, the second reactant 68 is removed from the chamber 82.

At step 124, the thickness of protective barrier coating 64 is determined. If the thickness is not appropriate according to predetermined values, the steps of forming the first monolayer solid thin film 114 - including step 112 - and forming said second monolayer solid thin film 120 - including steps 116 and 118 - can be repeated. The determination to repeat steps 112 and 122 is responsive to determining that the thickness of the protective barrier coating 64 is not within the specifications of the predetermined value, usually being too thin.

The chamber 82 can be returned to normal temperature and pressure at step 126. In another exemplary embodiment, in-situ thickness monitoring techniques such as ellipsometry and quartz crystal microbalance (QCM) can be employed for ALD. These techniques allow the process to be monitored in real-time and the process can be stopped when a desired thickness is reached without having to heat up/cool down the chamber.

In an exemplary embodiment a gas source 90 can be coupled to the first reactant 66 supply and second reactant 68 supply. Optionally, a vacuum pump 92 can be coupled to the chamber 82 (internal passages 60), manifold 84 and lines 86, 88 to enable the coating system 80 to operate under vacuum/low pressure as required.

The exemplary coating process involves atomic layer deposition (ALD) of oxides to form the nanometer-scale layers 76. Atomic layer deposition is one method that can be used to deposit thin, conformal, defect free metallic, ceramic, oxide or non-oxide protective barrier coating 64 to complex geometries with excellent thickness control and complete non-line-of-sight capability.

The exemplary process forms a thin coating 64 that is required which can protect an alloy of the internal surfaces 62 from oxidation, while causing a minimal debit to high cycle fatigue/low cycle fatigue/thermo-mechanical fatigue.

The protective barrier coating has a thickness configured to minimize a fatigue debit of the blade/vane.

The protective barrier coating of Al₂O₃ material includes the advantage of having reasonable chemical stability in the presence oxidation at elevated temperatures seen proximate the internal surfaces.

The protective barrier coating as formed by the process herein includes the advantage of increased engine time on wing, reduced scrap rates for costly long lead-time parts.

The protective barrier coating as formed by the process herein includes the advantage of a non-line-of-sight coating technique.

The protective barrier coating as formed by the process herein includes the advantage of having the capacity to deposit oxide/nitride layers which can act as effective barriers to high temperature oxidation.

The protective barrier coating as formed by the process herein includes the advantage of depositing thin layers that minimize fatigue debits.

The protective barrier coating as formed by the process herein includes the advantage of having low part temperatures during the coating process, typically a few hundred degrees Centigrade. In alternative embodiments, one can deposit the protective barrier coating as close to the ultimate use temperature as possible. ALD is generally kept to lower temperatures because it is preferred to work below the thermal decomposition limits of the ALD precursors.

There has been provided a process for coating. While the process for coating has been described in the context of specific embodiments thereof, other unforeseen alternatives, modifications, and variations may become apparent to those skilled in the art having read the foregoing description. Accordingly, it is intended to embrace those alternatives, modifications, and variations which fall within the broad scope of the appended claims.

## Claims

1. A process for coating a gas turbine engine airfoil (32) comprising:
coupling said airfoil (32) having an internal surface (62) with a chamber, said chamber configured to perform atomic layer deposition;
injecting a first reactant (66) into said chamber so as to form a first monolayer gas thin film on said internal surface (62);
removing said first reactant (66) from said chamber;
injecting a second reactant (68) into said chamber so as to react to form a monolayer solid thin film (72);
removing said second reactant (68) from said chamber; and
forming a protective barrier coating (64) on said internal surface (62).

2. The process of claim 1, further comprising:
determining a thickness (T) of said protective barrier coating (64); and
repeating the steps of injecting and removing said first reactant (66) and repeating the step of injecting and removing said second reactant (68) responsive to determining said thickness (T) of said protective barrier coating (64).

3. The process of claim 1 or 2, further comprising:
prior to injecting said first reactant (66) into said chamber, creating a predetermined pressure in said chamber; and
heating said chamber to a predetermined temperature, wherein, optionally, said predetermined temperature enables said step of forming a first monolayer gas thin film on said internal surface (62) and said step of injecting said second reactant (68) to form said monolayer solid thin film (72).

4. The process of claim 1, 2 or 3, wherein said first reactant (66) comprises an oxide or metal precursor and said second reactant (68) comprises an oxidant.

5. The process of any preceding claim, wherein:
said first monolayer gas thin film and said second reactant (68) react to form said protective barrier coating (64) comprising Al₂O₃; or
said first reactant (66) and said second reactant (68) form the protective barrier coating (64) comprising a material selected from the group consisting of Ta₂O₅, ZrO₂, TiO_{2,} Cr₂O₃ and precursors selected from the group consisting of Me- halides, alkyls, alkoxides, β-diketonates, where Me = Al, Cr, Ti, Si, Zr, Hf, Y, Ta, Nb, Ce, La, Yb, Mg, Ni, Co, and Mn.

6. The process of any preceding claim, wherein said protective barrier coating (64) comprises a total thickness (T) of from about 0.1 micron to about 10 microns, and, optionally, said total thickness (T) is configured to reduce internal corrosion.

7. The process of any preceding claim, further comprising:
after completion of forming said protective barrier coating (64), bringing said chamber to an ambient temperature and pressure.

8. The process of any preceding claim, wherein said internal surface (62) is located in an airfoil internal cooling passage (60).

9. The process of claim 8, further comprising:
coupling a manifold (84) configured to flow said first reactant (66) and said second reactant (68) into said internal cooling passage (60);
flowing said first reactant (66) into said internal cooling passage (60);
removing said first reactant (66) from said internal cooling passage (60);
flowing said second reactant (68) into said internal cooling passage (60); and
removing said second reactant (68) from said internal cooling passage (60).

10. The process of claim 8 or 9, further comprising:
masking airfoil surfaces not intended for coating.

11. A gas turbine engine airfoil internal surface (62) comprising:
a protective barrier coating (64) formed by the method of any preceding claim.

12. The gas turbine engine airfoil internal surface (62) according to claim 11, wherein:
said protective barrier coating (64) comprises Al₂O₃; or
said protective barrier coating (64) is a material selected from the group consisting of Ta₂O₅, ZrO₂, TiO_{2,} Cr₂O₃ and precursors selected from the group consisting of Me-halides, alkyls, alkjoxides, β-diketonates, where Me = Al, Cr, Ti, Si, Zr, Hf, Y, Ta, Nb, Ce, La, Yb, Mg, Ni, Co, and Mn.

13. The gas turbine airfoil internal surface (32) according to claim 11 or 12, wherein said protective barrier coating (64) comprises multiple layers (72, 74).

14. The gas turbine engine airfoil internal surface (62) according to claim 11, 12 or 13, wherein said airfoil internal surface (62) is an internal surface of one of a blade of a high pressure turbine and a vane of a high pressure turbine.

15. The gas turbine engine airfoil internal surface (32) according to any of claims 11 to 14, wherein said protective barrier coating (64) has a thickness (T) configured to minimize an internal corrosion at temperatures exceeding 1800 degrees Fahrenheit (982.2°C).
